# EUROPEAN PATENT APPLICATION

(11) **EP 1 120 824 A2**
(43) Date of publication of application: **01.08.2001**
(21) Application number: 00128765.5
(22) Date of filing: 30.12.2000
(51) Int. Cl.: H01L 21/56

(54) **Process for producing an ic chip having a protective layer**

(30) Priority: 27.01.2000 JP 2000018545
(71) Applicant: LINTEC Corporation, Tokyo 173-0001 (JP)
(72) Inventor: Nakata, Yasukazu, Matsudo-shi, Chiba 271-0044 (JP); Taguchi, Katsuhisa, Koshigaya-shi, Saitama 343-0841 (JP); Takahara, Toru, Urawa-shi, Saitama 336-0026 (JP)
(74) Representative: Gille Hrabal Struck Neidlein Prop Roos

(57) **Abstract**

A process for producing an IC chip having a protective layer is provided. The process comprises attaching an adhesive sheet comprising a base material and a layer of a curable resin disposed on one face of the base material to at least one face of an IC chip attached to a circuit substrate under pressure in a manner such that the layer of a curable resin contacts the face of the IC chip and curing the layer of a curable resin.

A uniform protective layer having an accurate shape can be formed on an IC chip in a thin sheet IC circuit such as an IC card efficiently in a simple operation so that formation of cracks in the IC chip can be prevented.

## Description

### BACKGROUND OF THE INVENTION

### 1. Field of the Invention

The present invention relates to a process for producing an IC chip having a protective layer. More particularly, the present invention relates to a process for producing an IC chip having a protective layer in accordance with which a protective layer can be formed on an IC chip disposed on a thin sheet IC circuit such as an IC card efficiently so that formation of cracks in the IC chip can be prevented.

### 2. Description of Related Art

IC chips have been used widely in various fields such as electronic instruments and information communication instruments. As the size and the weight of the electronic instruments and information communication instruments decrease, circuit wirings in IC chips are more integrated in multiple layers and the thickness of IC chips decreases.

IC cards are known as an application of the IC chip. In general, an IC card has a cover sheet integrally laminated to a substrate sheet on which an IC chip and related members such as antenna, a chip condenser, a battery and electronic circuits are disposed and prints, magnetic stripes and embosses for displaying various informations are formed on the surface of the cover sheet. Since IC cards have a great capacity for recording information and a high degree of security, IC cards have been developed and practically used as the cards replacing conventional magnetic cards in the fields of credit cards, ID cards, cashing cards and prepaid cards.

The thickness of IC chips in thin sheet IC circuits including IC cards is decreasing as described above.

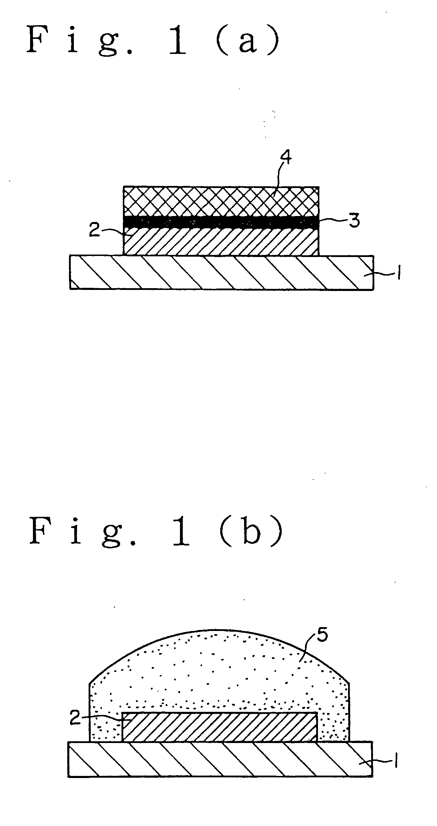

However, the decrease in the thickness of IC chips causes a problem in that the IC chips tends to be broken. To protect the thin IC chips, structures shown in Figure 1(a) and Figure 1(b) are currently used.

Figure 1(a) and Figure 1(b) show schematic sectional views of IC chips exhibiting two different conventional structures for protecting IC chips.

In the structure shown in Figure 1(a), an IC chip 2 attached to a circuit substrate 1 is protected with a metal plate 4 such as a foil of stainless steel which is disposed on the IC chip 2 via an adhesive layer 3. In the structure shown in Figure 1(b), an IC chip 2 attached to a circuit substrate 1 is protected with a potting resin 5 which is placed over the IC chip 2 by potting a liquid thermosetting resin such as an epoxy resin, followed by curing the resin by heating.

However, to form the structure shown in Figure 1(a) in which the IC chip is protected with a metal plate, it is necessary that a metal plate having the size of the IC chip or larger be prepared by punching out of a material steel plate, the obtained metal plate be coated with an adhesive and the coated metal plate be attached to the IC chip. Therefore, this structure has a drawback in that the process for forming the structure becomes complicated and the cost of production increases.

The structure shown in Figure 1(b) in which the IC chip is protected with a potting resin has drawbacks in that the resin which seals the IC chip after being cured has an irregular shape and that the resin has a considerable thickness. Therefore, it is difficult that a circuit having the desired small thickness is obtained.

### SUMMARY OF THE INVENTION

The present invention has an object to provide a process in accordance with which a uniform protective layer having an accurate shape can be formed on an IC chip in a thin sheet IC circuit such as an IC card efficiently in a simple operation so that formation of cracks in the IC chip can be prevented.

The present invention provides:
(1) A process for producing an IC chip having a protective layer which process comprises attaching an adhesive sheet comprising a base material and a layer of a curable resin disposed on one face of the base material to at least one face of an IC chip attached to a circuit substrate under pressure in a manner such that the layer of a curable resin contacts the face of the IC chip and curing the layer of a curable resin;
(2) A process described in (1), wherein the layer of a curable resin is cured by irradiation of an active light; and
(3) A process described in (1), wherein the layer of a curable resin is cured by heating.

### BRIEF DESCRIPTION OF THE DRAWINGS

Figure 1(a) and Figure 1(b) show schematic sectional views of IC chips exhibiting two different conventional structures for protecting the IC chips.

Figure 2 shows a diagram exhibiting an example of the process for producing an IC chip having a protective layer of the present invention.

The numbers in the Figures have the following meanings:
1: A circuit substrate
2: An IC chip
3: An adhesive layer
4: A metal plate
5: A potting resin
6: A layer of a curable resin
6': A layer of a cured resin
7: A base material
10: An adhesive sheet

### DESCRIPTION OF THE PREFERRED EMBODIMENTS

In the process for producing an IC chip having a protective layer of the present invention, an IC chip attached to a circuit substrate is used. The form of the circuit substrate is not particularly limited and is suitably selected in accordance with the application. For example, when the circuit substrate is used for an IC card, a circuit substrate having an insulating sheet is used and an antenna coil and a circuit pattern which is made of a conductive thin film and used for disposing electronic members such as an IC chip and the like are formed on the insulating sheet.

The insulating sheet described above is not particularly limited as long as the sheet has the electric insulating property and can be suitably selected from insulating sheets conventionally used for circuit substrates for IC cards. Examples of the insulating sheet include insulating sheets made of paper, wood materials and synthetic resins such as polyethylene, polyesters, polypropylene, polyvinyl chloride, acrylic resins, polycarbonates, polyimides, epoxy resins, urea resins, urethane resins and melamine resins. Among these insulating sheets, flexible sheets made of polyesters are preferable and flexible sheets made of polyethylene terephthalate are more preferable. The thickness of the sheet is generally about 10 to 500 µm and preferably 25 to 250 µm.

The process for forming an antenna coil on the insulating sheet is not particularly limited and a conventional process can be used. For example, a coil prepared by winding an insulated conductive wire in a flat planar form may be embedded into the insulating sheet; a conductive paste may be applied to the surface of the insulating sheet in accordance with the silk screen printing process to form an antenna coil; or a conductive thin film may be formed on the surface of the insulating sheet and an antenna coil may be formed by etching the formed conductive thin film in accordance with the lithography. The process for forming a circuit pattern of an conductive thin film on the insulating sheet is not particularly limited and a conventional process can be used. For example, a conductive metal foil such as a copper foil or an aluminum foil may be attached to an insulating sheet; a thin film of a conductive metal such as a thin film of copper or aluminum may be formed on an insulating sheet in accordance with the vapor deposition process or the thermal spraying process and a circuit pattern may be formed by etching the formed thin film in accordance with the lithography; or a conductive paste may be attached to the surface of the insulating sheet in accordance with the silk screen printing process to form a circuit pattern.

When the antenna coil or the circuit pattern is formed with a conductive paste in accordance with a printing process, the conductive paste comprises metal powder such as silver powder, a binder resin, a plasticizer and a solvent. It is preferable that the binder resin is a resin of the same type as that of the substrate sheet so that the binder resin has the same properties (such as the coefficient of thermal expansion and the degree of contraction) as those of the substrate sheet.

In the present invention, an IC chip and, where necessary, other electronic members such as chip condensers are disposed on the circuit substrate thus prepared. The method for disposing these members is not particularly limited and can be selected from convention methods in accordance with the situation. For example, the wire bonding method or the TAB method (the tape automated bonding method) may be used as the method of bonding an electronic member to the circuit substrate when the electronic member is disposed on the substrate sheet. Alternatively, an electric member may be directly bonded to the circuit substrate in accordance with the flip chip method in which the IC chip or the like is flipped and directly attached to the circuit substrate. The flip chip method is preferable since the thickness can be reduced.

In the present invention, a protective layer comprising a layer of a cured resin is formed on at least one face of the IC chip attached to (disposed on) the circuit substrate. The protective layer may be formed on the upper face of the IC chip or on the back face of the circuit substrate. In general, the protective layer is formed on the upper face of the IC chip.

As the process for forming the above protective layer, in general, an adhesive sheet comprising a base material and a layer of a curable resin formed on one face of the base material is attached to at least one face of the IC chip under pressure in a manner such that the layer of a curable resin contacts the face of the IC chip. The layer of a curable resin is then cured without removing or after removing the base material in the adhesive sheet and a protective layer is formed. As the method of curing, irradiation of an active light, heating or irradiation of an active light, followed by heating may be used.

Examples of the base material used for the above adhesive sheet include paper such as glassine paper, coated paper and laminated paper and various types of plastic films which are coated with a releasing agent such as a silicone resin. The thickness of the base material is not particularly limited and, in general, about 20 to 150 µm.

When the layer of a curable resin is cured by irradiation of an active light without removing the base material, it is important that a base material which transmits the active light is used as the base material. When the layer of a curable resin is cured by heating without removing the base material, it is important that a base material which withstands the heating temperatures is used as the base material.

For the layer of a curable resin disposed on one face of the base material, a resin composition curable by irradiation of an active light or a resin composition curable by heating is used.

As the above resin composition curable by irradiation of an active light, a resin composition curable by irradiation of ultraviolet light is preferable. The resin composition curable by irradiation of ultraviolet light is not particularly limited and can be suitably selected from conventional resin compositions curable by irradiation of ultraviolet light. In general, the resin composition curable by irradiation of ultraviolet light comprises a photopolymerizable polymer or photopolymerizable prepolymer as the main component and, where desired, other resins, reactive diluents and photopolymerization initiators. The above photopolymerizable polymer and prepolymer include photopolymerizable polymers and prepolymers of the radical polymerization type and the cationic polymerization type. The photopolymerizable polymers and prepolymers of the radical polymerization type are compounds having a carbon-carbon double bond such as urethane (meth)acrylates, polyester (meth)acrylates, polyether (meth)acrylates, epoxy (meth)acrylates and compounds having a carbon-carbon double bond in a side chain or in the main chain of poly(meth)acrylic esters. The photopolymerizable polymers and prepolymers of the cationic polymerization type are compounds having glycidyl group such as polyether glycidyls, polyester glycidyls, alicyclic epoxy resins, heterocyclic epoxy resins, epoxy resins of the novolak type, epoxy resins of the bisphenol A type, epoxy resins of the bisphenol F type, epoxy resins of the bisphenol AD type and compounds having glycidyl group in a side chain or in the main chain of poly(meth)acrylic esters. The molecular weight of the photopolymerizable polymer and prepolymer is generally about 2,000 to 2,000,000. The photopolymerizable polymer and prepolymer may be used singly or in combination of two or more.

Examples of the other resin described above include vinyl resins, urethane resins, polyesters, polyamides, polycarbonates, phenol resins, urea resins, melamine resins, polyimides, nitrile resins and silicone resins. These resins are used for adjusting viscosity of a liquid composition for coating and for providing desired physical properties to the layer of the cured resin. The above resins may be used singly or in combination of two or more.

The above reactive diluent has the function of providing elasticity or rigidity to the cured product in addition to the function as the reactive diluent. As the reactive diluent, any of monofunctional reactive diluents and polyfunctional reactive diluents can be used. Examples of the reactive diluent include cyclohexyl (meth)acrylate, 2-ethylhexyl (meth)acrylate, lauryl (meth)acrylate, stearyl (meth)acrylate, 1,4-butanediol di(meth)acrylate, 1,6-hexanediol di(meth)acrylate, neopentyl glycol di(meth)acrylate, polyethylene glycol di(meth)acrylate, neopentyl glycol adipate di(meth)acrylate, neopentyl glycol hydroxypivalate di(meth)acrylate, dicyclopentanyl di(meth)acrylate, dicyclopentenyl di(meth)acrylate modified with caprolactone, di(meth)acrylate phosphate modified with ethylene oxide, cyclohexyl di(meth)acrylate modified with allyl group, di(meth)acrylate modified with ethylene oxide isocyanurate, trimethylolpropane tri(meth)acrylate, dipentaerythritol di(meth)acrylate, dipentaerythritol tri(meth)acrylate modified with propionic acid, pentaerythritol tri(meth)acrylate, trimethylolpropane tri(meth)acrylate modified with propylene oxide, tris(acryloxyethyl) isocyanurate, dipentaerythritol penta(meth)acrylate modified with propionic acid, dipentaerythritol hexa(meth)acrylate and dipentaerythritol hexa(meth)acrylate modified with caprolactone. The reactive diluent may be used singly or in combination of two or more.

Examples of the photopolymerization initiator for the photopolymerizable polymers and prepolymers of the radical polymerization type include benzoin, benzoin methyl ether, benzoin ethyl ether, benzoin isopropyl ether, benzoin n-butyl ether, benzoin isobutyl ether, acetophenone, dimethylaminoacetophenone, 2,2-dimethoxy-2-phenylacetophenone, 2,2-diethoxy-2-phenylacetophenone, 2-hydroxy-2-methyl-1-phenylpropane-1-one, 1-hydroxycyclohexyl phenyl ketone, 2-methyl-1-[4-(methylthio)phenyl]-2-morpholinopropane-1-one, 4-(2-hydroxyethoxy)phenyl 2-(hydroxy-2-propyl) ketone, benzophenone, p-phenylbenzophenone, 4,4'-diethylaminobenzophenone, dichloro-benzophenone, 2-methylanthraquinone, 2-ethylanthraquinone, 2-tert-butylanthraquinone, 2-aminoanthraquinone, 2-methylthioxanthone, 2-ethylthioxanthone, 2-chlorothioxanthone, 2,4-dimethylthioxanthone, 2,4-diethylthioxanthone, benzyl dimethyl ketal, acetophenone dimethyl ketal and esters of p-dimethylaminobenzoic acid. Example of the photopolymerization initiator for the photopolymerizable polymers and prepolymers of the cationic polymerization type include compounds obtained from oniums such as aromatic sulfonium ions, aromatic oxosulfonium ions, aromatic diazonium ions and aromatic iodonium ions and anions such as tetrafluoroborate, hexafluorophosphate, hexafluoroantimonate and hexafluoroarsenate. Specific examples include p-methoxybenzenediazonium hexafluorophosphate, diphenyliodo hexafluorophosphate and triphenylsulfonium hexafluoroantimonate.

The resin composition curable by heating is not particularly limited and can be suitably selected from conventional resin compositions curable by heating. The resin composition curable by heating, in general, comprises a resin curable by heating as the main component and, where desired, other resins and curing agents. In general, the resins curable by heating having a molecular weight of about 200 to 2,000,000 are used.

Examples of the resin curable by heating include acrylate polymers which have a carbon-carbon double bond or glycidyl group, unsaturated polyesters, isoprene polymers, butadiene polymers, epoxy resins, phenol resins, urea resins and melamine resins. The resin curable by heating may be used singly or in combination of two or more.

Examples of the other resin described above include vinyl resins, urethane resins, polyesters, polyamides, polycarbonates, polyimides, nitrile resins and silicone resins. These resins are used for adjusting viscosity of a liquid composition for coating and for providing desired physical properties to the layer of the cured resin. The resins may be used singly or in combination of two or more.

Examples of the curing agent include organic peroxides such as dibenzoyl peroxide, dilauroyl peroxide, t-butyl peroxybenzoate and di-2-ethylhexyl peroxydicarbonate; azo compounds such as 2,2'-azobisisobutyronitrile, 2,2'-azobis-2-methylbutylronitrile and 2,2'-azobisdimethylvaleronitrile; polyisocyanate compounds such as tolylene diisocyanate, diphenylmethane diisocyanate, isophorone diisocyanate and hexamethylene diisocyanate; polyamines such as phenylenediamine, hexamethylenetetramine, isophoronediamine and diaminodiphenylmethane; acid anhydrides such as dodecenylsuccinic anhydride, phthalic anhydride and tetrahydrophthalic anhydride; imidazoles such as 2-methylimidazole, 2-ethylimidazole and 2-phenylimidazole; dicyandiamide; Lewis acids such as p-toluenesulfonic acid and trifluoromethanesulfonic acid; and formaldehyde. The curing agent is suitably selected in accordance with the type of the used resin curable by heating.

In the present invention, a liquid composition for coating comprising the above resin composition curable by irradiation of an active light or the above resin composition curable by heating is prepared. In this preparation, where necessary, suitable organic solvents may be used. Various types of fillers may also be added to improve bending modulus of the layer of the cured resin, stabilize the degree of contraction of the volume and enhance the heat resistance.

Examples of the solvent which is used where necessary include aliphatic hydrocarbons such as hexane, heptane and cyclohexane; aromatic hydrocarbons such as toluene and xylene; halogenated hydrocarbons such as methylene chloride and ethylene chloride; alcohols such as methanol, ethanol, propanol and butanol; ketones such as acetone, methyl ethyl ketone, 2-pentanone and isophorone; esters such as ethyl acetate and butyl acetate; and cellosolve solvents such as ethylcellosolve. Examples of the filler include silica, alumina and hydrated alumina.

The concentration and the viscosity of the prepared liquid composition for coating is not particularly limited as long as the liquid composition can be used for coating and can be suitably selected in accordance with the situation.

In the present invention, the liquid composition for coating comprising the resin composition curable by irradiation of an active light or the resin composition curable by heating is applied to one face of the base material described above to coat the face in accordance with a convention process such as the bar coating, the knife coating, the roll coating, the blade coating, the die coating and the gravure coating. A coating film is formed on the face and then dried. Thus, a layer of the curable resin is formed and the desired adhesive sheet is obtained. The thickness of the layer of the curable resin is selected generally in the range of 10 to 200 µm, preferably in the range of 20 to 120 µm and more preferably in the range of 30 to 70 µm. The thickness of the IC chip is generally about 30 to 170 µm.

It is preferable that the bending modulus of the layer of the curable resin after being cured (the layer of the cured resin) is in the range of 1.0 to 30 GPa. When the bending modulus is smaller than 1.0 GPa, there is the possibility that the protective effect on the IC chip is not sufficiently exhibited. When the bending modulus exceeds 30 GPa, the layer of the cured resin becomes brittle. The bending modulus is more preferably in the range of 1.5 to 15 GPa and most preferably in the range of 2 to 5 GPa from the above reason.

The bending modulus of the layer of the cured resin is measured in accordance with the method described in "Method of Bending Test of Hard Plastics" of Japanese Industrial Standard K 7203-1982.
In the process of the present invention, the adhesive sheet prepared as described above is attached to at least one face of the IC chip attached to (disposed on) the circuit substrate under pressure in a manner such that the layer of the curable resin contacts the face of the IC chip. The size of the adhesive sheet is not particularly limited as long as the size is the same as or larger than the object of the protection. It is practically preferable that the size is 100 to 200% and more preferably 100 to 150% of the size of the object of the protection. In general, the size of an IC chip is a square of 5 mm or smaller.

The IC chip to which the adhesive sheet has been attached in the above is irradiated by an active light or heated to cure the layer of the curable resin without removing the base material or after removing the base material and a layer of the cured resin as the protective layer is formed. Where necessary, the layer of the curable resin may be preliminarily cured by irradiating an active light and may then be cured by heating to form a protective layer of the cured resin.

In the process of curing by irradiation of an active light, ultraviolet light is preferable as the active light. Ultraviolet light can be obtained from a high voltage mercury lamp, a fusion H lamp or a xenon lamp. When the irradiation is conducted without removing the base material, the IC chip is irradiated by ultraviolet light at the side of the base material since a base material transmitting ultraviolet light is used. When the irradiation is conducted after the base material is removed, the layer of the curable resin can be irradiated directly by ultraviolet light.

As the condition of the irradiation, an intensity of irradiation in the range of 10 to 500 W/cm is preferable and a time of irradiation in the range of 0.1 second to 10 minutes is sufficient.

In the process of curing by heating, it is preferable that the curing by heating is conducted using a thermostat or an infrared heating lamp. As the condition of the heating, a temperature in the range of 50 to 300°C is preferable and a time of heating in the range of 1 minute to 5 hours is sufficient.

After the layer of the curable resin is cured as described above, the base material may be removed when the base material is still attached and the lamination treatment described later is conducted. The lamination treatment may be conducted without removing the substrate, where desired.

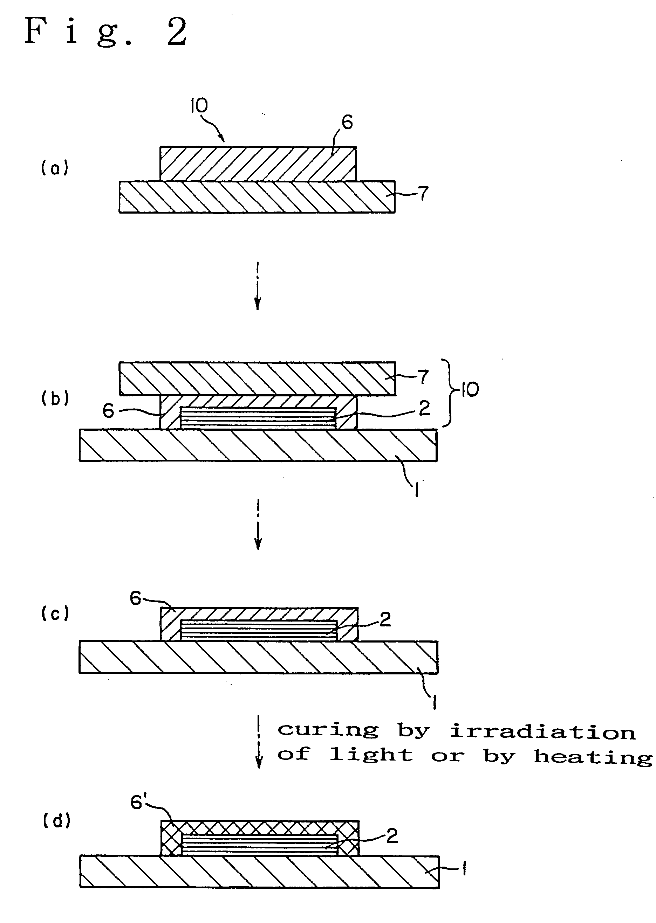

Figure 2 shows a diagram exhibiting an example of the process for producing an IC chip having a protective layer of the present invention.

In step (a), a layer of a curable resin 6 is formed on one face of a base material 7 and an adhesive sheet 10 is prepared. In step (b), the adhesive sheet 10 is attached to the upper face of an IC chip 2 attached to (disposed on) a circuit substrate 1 under pressure in a manner such that the layer of a curable resin 6 contacts the upper face of the IC chip 2.

In step (c), the base material 7 is removed. In the following step (d), the layer of a curable resin 6 is cured by irradiation of an active light or by heating and a layer of a cured resin 6' is formed as the protective layer.

In the process shown in Figure 2, the layer of a curable resin 6 is cured after the base material 7 is removed. Alternatively, the layer of a curable resin 6 may be cured by irradiation of an active light or by heating without removing the base material 7. Then, the lamination treatment of the following step (not shown in Figure 2) may be conducted after removing the base material 7 or without removing the base material.

In general, a sheet of a thermoplastic resin is laminated to the circuit substrate on which the IC chip having the protective layer of the cured resin is disposed. As the above sheet of a thermoplastic resin, a sheet of a thermoplastic resin made of the same material as or a different material from the material of the insulating sheet used in the circuit substrate may be used as long as the sheet of a thermoplastic resin can be sealed to the insulating sheet by heating. However, it is preferable that a sheet of a thermoplastic resin made of the same material as that of the insulating sheet used in the circuit substrate is used as the above sheet of a thermoplastic resin from the standpoint of tight adhesion. As the sheet of a thermoplastic resin, a sheet of a thermoplastic resin having excellent electric insulating property, high impact resistance and a relatively low heat sealing temperature is preferable. Examples of such a sheet include sheets of polyethylene, polyesters, polypropylene, polyvinyl chloride, acrylic resins, polycarbonates and polyurethanes. Among these sheets, sheets of polyesters are preferable and sheets of polyethylene terephthalate are more preferable. In the above lamination, the circuit substrate and the sheet of a thermoplastic resin may be laminated via a layer of an adhesive resin, where desired.

The advantages of the process for producing an IC chip having a protective layer of the present invention can be summarized as follows:
(1) A uniform and thin protective layer for an IC chip having an accurate shape can be formed in accordance with a simple operation.
(2) Handling, such as transportation, of a circuit substrate having an IC chip can be facilitated when a substrate is attached to a protective layer of a cured resin.
(3) Layers of a cured resin of the same type or different types can be formed on two faces of an IC chip attached to a circuit substrate as the protective layers.
(4) Formation of cracks in an IC chip in a thin sheet IC circuit such as an IC card can be effectively prevented.

### EXAMPLES

The present invention will be described more specifically with reference to examples in the following. However, the present invention is not limited to the examples.

The bending test of a layer of a cured resin and the bending test of a circuit were conducted in accordance with the following methods.
(1) Bending test of a layer of a cured resin
   In accordance with the same procedures as those conducted in Examples, a layer of a cured resin having the same thickness as that in Examples was prepared separately. The bending modulus of the prepared layer was measured in accordance with the method described in "Method of Bending Test of Hard Plastics" of Japanese Industrial Standard K 7203-1982.
(2) Bending test of a circuit
   Fifty test pieces were used for each test. Circuits treated by the lamination were used as the test pieces. After the test pieces were subjected to the bending test in accordance with the method of Japanese Industrial Standard X 6305, the test pieces were subjected to the communication test using a reader specifically designed for MYFAIR IC chips manufactured by PHILIPS Company. The number of test pieces which failed to read and write data normally was counted. The appearance of the attached chip was visually examined. The number of test pieces having cracked chips was counted and the faction of cracked chips was obtained.

### Reference Example

A circuit substrate was prepared by printing a coil pattern and a circuit pattern on a polyethylene terephthalate (PET) film having a thickness of 75 µm with a silver paste. To the prepared circuit substrate, a MYFAIR IC chip manufactured by PHILIPS Company (a square of 5 mm; the thickness: 120 µm) was attached via an anisotropic electric conductive film and a circuit substrate having an IC chip was obtained.

### Example 1

### (1) Preparation of an adhesive sheet

To 100 parts by weight of an urethane acrylate having a weight-average molecular weight of 10,000 as the photopolymerizable prepolymer, 100 parts by weight of dipentaerythritol diacrylate as the reactive diluent and 5 parts by weight of benzophenone as the photopolymerization initiator were added. To the obtained mixture, 305 parts by weight of ethyl acetate was added and a liquid composition for coating was prepared.

One face of a PET film (a base material) having a thickness of 38 µm which had been treated for releasing with a silicone resin was coated with the above liquid composition for coating using a knife coater. The coated base material was dried at 100°C for 3 minutes and an adhesive sheet having a layer of a curable resin having a thickness of 45 µm was prepared.

### (2) Protection of an IC chip

A piece of a square of 6 mm was punched out of the adhesive sheet prepared in (1). The obtained piece of the adhesive sheet was attached to the circuit substrate having an IC chip which was obtained in Reference Example in a manner such that the layer of the curable resin contacted the IC chip and the piece of the adhesive sheet covered the IC chip. After the adhesive sheet was attached to the circuit substrate, the base material in the adhesive sheet was removed and the remaining coated circuit substrate was irradiated by ultraviolet light at the side to which the adhesive sheet was attached using a mercury lamp under the condition of an intensity of irradiation of 120 W/cm, a distance between the lamp and the coated circuit substrate of 10 cm and a time of irradiation of 10 seconds. Thus, the layer of the curable resin was cured and the IC chip was protected. The layer of the cured resin had a bending modulus of 2.2 GPa.

### (3) Laminating treatment

A PET film having a thickness of 50 µm which had a layer of a polyester resin having a thickness of 50 µm was attached to the circuit substrate having an IC chip coated with the protective layer which was obtained in (2) on the face at the side of the IC chip in a manner such that the layer of a polyester resin contacted the circuit substrate and the lamination treatment was performed by passing the obtained product between silicone rubber rollers heated to 130°C.

The results of the bending test of the obtained card are shown in Table 1.

### Example 2

### (1) Preparation of an adhesive sheet

To 50 parts by weight of a liquid epoxy resin of the bisphenol A type (the molecular weight: 380; the epoxy equivalent: 190) and 100 parts by weight of a solid epoxy resin of the bisphenol A type (the weight-average molecular weight: 6,000; the epoxy equivalent: 4,000) as the polymers curable by heating, 10 parts by weight of dicyandiamide as the curing agent were added. To the obtained mixture, 150 parts by weight of methyl ethyl ketone was added and a liquid composition for coating was prepared.

One face of a PET film (a base material) having a thickness of 38 µm which had been treated for releasing with a silicone resin was coated with the above liquid composition for coating using a knife coater. The coated base material was dried at 100°C for 3 minutes and an adhesive sheet having a layer of a curable resin having a thickness of 50 µm was prepared.

### (2) Protection of an IC chip

A piece of a square of 6 mm was punched out of the adhesive sheet prepared in (1). The obtained piece of the adhesive sheet was attached to the circuit substrate having an IC chip which was obtained in Reference Example in a manner such that the layer of the curable resin contacted the IC chip and the piece of the adhesive sheet covered the IC chip. After the adhesive sheet was attached to the circuit substrate, the base material in the adhesive sheet was removed and the remaining coated circuit substrate was dipped into a thermostat at 130°C for 30 minutes. Thus, the layer of the curable resin was cured and the IC chip was protected. The layer of the cured resin had a bending modulus of 3.2 GPa.

### (3) Lamination treatment

The circuit substrate having an IC chip coated with the protective layer which was obtained in (2) was subjected to the lamination treatment on the face at the side of the IC chip in accordance with the same procedures as those conducted in Example 1 (3).

The results of the bending test of the obtained card are shown in Table 1.

### Example 3

### (1) Preparation of an adhesive sheet

To 100 parts by weight of a phenol novolak resin (the weight-average molecular weight: 1,000) and 50 parts by weight of an alicyclic epoxy resin (the molecular weight: 320; the epoxy equivalent: 200) as the curable resin composition, 10 parts by weight of p-methoxybenzenediazonium hexafluorophosphate as the photopolymerization initiator was added. To the obtained mixture, 150 parts by weight of methyl ethyl ketone was added and a liquid composition for coating was prepared.

One face of a PET film (a base material) having a thickness of 38 µm which had been treated for releasing with a silicone resin was coated with the above liquid composition for coating using a knife coater. The coated base material was dried at 100°C for 3 minutes and an adhesive sheet having a layer of curable resin having a thickness of 60 µm was prepared.

### (2) Protection of an IC chip

A piece of a square of 6 mm was punched out of the adhesive sheet prepared in (1). The obtained piece of the adhesive sheet was attached to the circuit substrate having an IC chip which was obtained in Reference Example in a manner such that the layer of the curable resin contacted the IC chip and the piece of the adhesive sheet covered the IC chip. After the adhesive sheet was attached to the circuit substrate, the base material in the adhesive sheet was removed and the remaining coated circuit substrate was irradiated by ultraviolet light at the side to which the adhesive sheet was attached using a mercury lamp under the condition of an intensity of irradiation of 120 W/cm, a distance between the lamp and the coated circuit substrate of 10 cm and a time of irradiation of 10 seconds. Thus, the layer of the curable resin was cured and the IC chip was protected. The layer of the cured resin had a bending modulus of 2.8 GPa.

### (3) Lamination treatment

The circuit substrate having an IC chip coated with the protective layer which was obtained in (2) was subjected to the lamination treatment on the face at the side of the IC chip in accordance with the same procedures as those conducted in Example 1 (3).

The results of the bending test of the obtained card are shown in Table 1.

### Comparative Example 1

Without forming a protective layer on the IC chip of the circuit substrate having an IC chip which was obtained in Reference Example, the lamination treatment was conducted in accordance with the same procedures as those conducted in Example 1 (3). The results of the bending test of the obtained card are shown in Table 1.

### Comparative Example 2

A piece of a square of 6 mm was punched out of a PET sheet having a thickness of 100 µm (the bending modulus measured in accordance with the method of Japanese Industrial Standard K 7203): 0.7 GPa) and attached to the IC chip of the circuit substrate having an IC chip which was obtained in Reference Example as the protective sheet. The lamination treatment was conducted in accordance with the same procedures as those conducted in Example 1 (3). The results of the bending test of the obtained card are shown in Table 1.

**Table 1**

| | Bending modulus of layer of cured resin (GPa) | Bending test of circuit | |
|---|---|---|---|
| | | fraction of failed communication | examination of appearance (fraction of cracked chips) |
| Example 1 | 2.2 | 0/50 | 0/50 |
| Example 2 | 3.2 | 0/50 | 0/50 |
| Example 3 | 2.8 | 0/50 | 0/50 |
| Comparative Example 1 | - | 32/50 | 12/50 |
| Comparative Example 2 | - | 24/50 | 3/50 |
| Note: In Comparative Example 2, the protective sheet alone had a bending modulus of 0.7 GPa. | | | |

## Claims

1. A process for producing an IC chip having a protective layer which process comprises attaching an adhesive sheet comprising a base material and a layer of a curable resin disposed on one face of the base material to at least one face of an IC chip attached to a circuit substrate under pressure in a manner such that the layer of a curable resin contacts the face of the IC chip and curing the layer of a curable resin.

2. A process according to Claim 1, wherein the layer of a curable resin is cured by irradiation of an active light.

3. A process according to Claim 1, wherein the layer of a curable resin is cured by heating.
